# EUROPÄISCHE PATENTSCHRIFT

(11) **EP 2 013 965 B1**
(45) Veröffentlichungstag und Bekanntmachung des Hinweises auf die Patenterteilung: **08.09.2010**
(21) Anmeldenummer: 06829524.5
(22) Anmeldetag: 12.12.2006
(51) Int. Cl.: H02N 2/00, H01L 41/09, F16D 65/14

(54) **PIEZOELEKTRISCHER MOTOR ZUR VERWENDUNG ALS FAHRZEUGANTRIEB, STELLANTRIEB UND DERGLEICHEN**
PIEZOELECTRIC MOTOR TO BE USED AS A VEHICLE DRIVE SYSTEM, ACTUATOR, AND SIMILAR
MOTEUR PIÉZOÉLECTRIQUE UTILISÉ COMME SYSTÈME DE PROPULSION DE VÉHICULE, SERVOMOTEUR ET ANALOGUE

(30) Priorität: 14.12.2005 DE 102005060164; 01.05.2006 DE 102006020566
(43) Veröffentlichungstag der Anmeldung: 14.01.2009
(73) Patentinhaber: Richter, Berta, 86163 Augsburg (DE)
(72) Erfinder: RICHTER, Hans, 86163 Augsburg (DE)
(74) Vertreter: Gallo, Wolfgang
(86) Internationale Anmeldenummer: PCT/EP2006/011938
(87) Internationale Veröffentlichungsnummer: WO 2007/068441

(56) Entgegenhaltungen:
- EP-B1- 0 624 912
- EP-B1- 0 706 226
- WO-A-03/005553
- DE-A1- 10 127 444
- JP-A- 60 187 270

## Beschreibung

Die Erfindung betrifft einen piezoelektrischen Motor, der insbesondere als Fahrzeugantrieb oder Stellantrieb vorgesehen ist, also für Anwendungen, bei denen hohe Antriebsleistungen erforderlich sind und die hohe Antriebskräfte und/oder hohe Drehzahlen erfordern. Der piezoelektrische Antrieb kann dabei sowohl als Drehantrieb wie auch als Linearantrieb eingesetzt werden.

Ein besonderes und bedeutsames Anwendungsgebiet der Erfindung ist der Einsatz als beispielsweise auf die Bremsscheiben wirkender Elektromotor im Rahmen von Hybrid-Kraftfahrzeugantrieben. '

Ein piezoelektrischer Antriebsmotor für hohe Antriebsleistungen, der auch als Schwerlastantrieb konzipiert ist, ist bereits aus der WO 03/005 553 A2 bekannt.

Der dort beschriebene piezoelektrische Antrieb weist eine Mehrzahl von Piezopaketen in Gestalt von Piezoelementenstapeln an, die zwischen einen relativ feststehenden Bezugsteil und einem relativ dazu bewegten Abtriebsteil angeordnet sind. Diese Piezopakete dienen zum selektiven Erzeugen einer Klemmkraft zwischen Bezugsteil und Abtriebsteil und werden daher als Klemmpiezopakete bezeichnet. Diese Klemmpiezopakete sind jeweils mit einem Ende der Piezoelementenstapelanordnung am Bezugsteil festgelegt und stützen sich mit dem anderen Ende auf dem Abtriebsteil ab, ohne daran festgelegt zu sein. Die Orientierung der Reihe, in welcher diese Klemmpiezopakete nebeneinander angeordnet sind, verläuft quer zur Richtung der Relativbewegung zwischen Abtriebsteil und Bezugsteil.

Weitere, ebenfalls jeweils als Piezoelementenstapel ausgebildete Piezopakete, die wegen Ihrer Funktion als Schrittpiezopakete bezeichnet werden, sind mit ihrer Stapelhöhenrichtung etwa senkrecht zur Stapelhöhenrichtung der Klemmpiezopakete und in Richtung der Relativbewegung zwischen Bezugsteil und Abtriebsteil orientiert. Diese Schrittpiezopakete sind jeweils mit einem Ende ihrer Piezoelementenstapelanordnung wiederum am Bezugsteil festgelegt und mit dem anderen Ende mit dem sich auf dem Abtriebsteil abstützenden Ende jeweils eines zugeordneten Klemmpiezopakets (oder einer zugeordneten Untergruppe von Klemmpiezopaketen) verbunden.

Es sind zwei Gruppen von Klemmpiezopaketen und zwei Gruppen von Schrittpiezopaketen vorhanden. Diese werden elektrisch so angesteuert, dass jeweils die eine Gruppe von Klemmpiezopaketen aktiviert, d. h. im Sinne einer Expansion elektrisch beaufschlagt wird und diese Klemmpiezopakete sich klemmend an das Abtriebsteil anlegen, während die andere Gruppe von Klemmpiezopaketen deaktiviert, also in Lösestellung, d. h. nicht mit dem Abtriebsteil klemmend, geschaltet ist. Dann wird die der klemmend geschalteten Klemmpiezopaketgruppe zugeordnete Gruppe von Schrittpiezopaketen aktiviert, so dass die betreffenden Schrittpiezopakete sich dehnen und dadurch die auf dem Abtriebsteil klemmenden Enden der Klemmpiezopakete um eine entsprechende Distanz in Bewegungsrichtung des Abtriebsteils auslenken. Dadurch bewegt sich das Abtriebsteil um eine entsprechende Distanz unter den in Lösestellung geschalteten Klemmpiezopaketen der anderen Klemmpiezopaketgruppe hinweg. Danach wird die Ansteuerung umgeschaltet, d. h. die zuvor klemmenden Klemmpiezopakete werden in Lösestellung geschaltet, ebenso die zugehörigen Schrittpiezopakete, so dass die zuvor klemmenden Klemmpiezopakete sich aus der Klemmstellung lösen und in ihre Ausgangslage zurückkehren, während gleichzeitig die andere Gruppe von Klemmpiezopaketen, die vorher in der Lösestellung waren, durch Aktivierung in die klemmende Position geschaltet und danach auch deren Schrittpiezopakete aktiviert werden. Auf diese Weise erzeugen die beiden Gruppen von Klemmpiezopaketen mit jeweils zugeordneten Schrittpiezopaketen durch ihren alternierenden Einsatz eine fortlaufende Schrittfolge, wodurch das Abtriebsteil schrittweise bewegt wird. Da diese Ansteuerung der Piezopakete im Frequenzbereich von einigen Kilohertz, z. B. 25 kHz, erfolgt, erhält man eine quasi-kontinuierliche Bewegung des Abtriebsteils relativ zum Bezugsteil.

Bei dem aus der WO 03/005 553 bekannten piezoelektrischen Antrieb ist das Bezugsteil über eine "halbsteife" Brückenplatte mit den festgelegten Stapelenden der Klemmpiezopakete verbunden. Dabei bedeutet "halbsteif', dass die Brückenplatte sich mindestens im Längentoleranz- und Dehnungshubbereich der Klemmpiezopakete im statischen Zustand Stapelhöhendifferenzen der Klemmpiezopakete biegeelastisch anpasst, in dynamischen Zustand bei der Betriebsfrequenz sich jedoch im wesentlichen starr verhält. Dem liegt die Erkenntnis zugrunde, dass die Bewegungen der Piezopakete außerordentlich klein sind. Der verfügbare Dehnungsweg eines Piezopakets beträgt etwa ein Tausendstel der Stapelhöhe. Bei einer Stapelhöhe der Klemmpiezopakete von ca. 20 mm ergibt sich damit eine Dehnungsauslenkung von etwa 20 Mikrometer. Andererseits liegend die Toleranzen der mechanischen Bauteile des Antriebs selbst bei hochpräziser Fertigung jedenfalls im Hundertstel-Millimeterbereich. Auch die Stapelhöhe der Piezopakete unterliegt Fertigungstoleranzen, so dass bei einer Reihe von nebeneinander angeordneten Piezopaketen diese alle innerhalb dieser Toleranzen unterschiedlich hoch sind. Die Anordnung nach der WO 03 005 553 trägt diesen Gegebenheiten durch das Vorsehen der "halbsteifen" Brücke Rechnung und schafft damit die Vorraussetzung für die praktische Funktionsfähigkeit eines solchen piezoelektrischen Antriebs, der für hohe Antriebsleistungen geeignet ist, weil dadurch die funktionsnotwendige Vorraussetzung geschaffen wird, dass die Klemmpiezopakete zwischen Bezugsteil und Abtriebsteil stets unter straffer Vorspannung gehalten werden, da sonst bei dem verfügbaren Dehnungshub die geforderte Klemmkraft und somit die notwendige Reibkraft zum Bewegen des Abtriebsteils nicht erreicht werden könnte. Das Abtriebsteil, an dem sich die freien Enden der Klemmpiezopakete abstützen, ist in Relation zur "halbsteifen" Brücke steif ausgebildet.

Aufgabe der vorliegenden Erfindung ist es, eine Weiterentwicklung dieses aus der WO 03/005 553 bekannten Prinzips eines piezoelektrischen Antriebs aufzuzeigen, insbesondere im Hinblick auf die wirtschaftliche praktische Herstellbarkeit solcher piezoelektrischer Antriebe und, angesichts der Tendenz zur Ausstattung von Kraftfahrzeugen mit zwischen Elektroantrieb und Brennkraftantrieb wahlweise umschaltbaren Hybridantrieben, auch insbesondere im Hinblick auf den Einsatz als elektrischer Antrieb im Rahmen solcher Hybridantriebskonzepte. Dabei soll auch die Nachrüstbarkeit bei nur mit Brennkraftantrieb ausgerüsteten Kraftfahrzeugen in Betracht gezogen werden, so dass ein weiteres Ziel der Erfindung auch darin besteht, einen solchen piezoelektrischen Antrieb als auf eine Bremsscheibe eines Kraftfahrzeugs (oder eine dazu ähnliche Antriebsscheibe) wirkenden Antrieb auszubilden.

Ein wesentlicher Gesichtspunkt der vorstehend dargestellten Aufgabe besteht darin, die Anordnung eine piezoelektrischen Motors so auszubilden, dass je nach Anwendungszweck kleine oder große, ggf. in einem weiten Bereich veränderbare Antriebsgeschwindigkeiten oder die Erzeugung extrem hoher Antriebskräfte bei niedrigen Geschwindigkeiten erzeugbar sind.

Diese Aufgabe wird gemäß der Erfindung durch die im Anspruch 1 angegebene Ausbildung eines piezoelektrischen Antriebs gelöst. Ausgestaltungen und Weiterbildungen dieser Erfindung sind Gegenstand der Unteransprüche.

Die im Anspruch 1 in ihrem Kern beschriebene Erfindung beinhaltet damit eine konstruktive Ausbildung der aus der WO 03/005 553 im Prinzip bekannten "halbsteifen" Brücke in Gestalt separater, reibschlüssig zusammengespannter Brückenelemente oder auch in Gestalt einstückig über Materialbrücken zusammenhängende Brückenelemente, die jeweils einem der Klemmpiezopakete zugeordnet sind.

Durch Wahl der Geometrie der Anordnung, insbesondere der relativen Positionierung der Verbindungsstelle zwischen dem Schrittpiezopaket und dem Fuß sowie zwischen dem Fuß und dem Gegenlager kann ein dem jeweiligen Anwendungszweck optimal angepasstes "Übersetzungsverhältnis" zwischen Schrittpiezoauslenkung und Fußauslenkung an dessen Angriffsstelle am Abtriebsteil eingestellt werden.

Für die Anwendung als Kraftfahrzeugantrieb ist nach der Erfindung insbesondere vorgesehen, dass den Klemmpiezopaketen jeweils zwei Schrittpiezopakete zugeordnet sind, die gegensinnig angeordnet sind, um eine kurze Distanz in Stapelrichtung der Klemmpiezopakete versetzte Wirkungslinien und Angriffstellen an einem Fuß des jeweiligen Klemmpiezopakets haben, und wobei die Distanz zwischen den Angriffsstellen der Schrittpiezopakete am Fuß des Klemmpiezopaktes ein Mehrfaches der Distanz zwischen dem abtriebsteilseitigen Fußende und der diesem nächst gelegenen Angriffsstelle ist. Durch die gegenläufigen Auslenkungsbewegungen der Schrittpiezopakete und das Distanzverhältnis der Distanzen zwischen den beiden Angriffsstellen und dem Abtriebsteil und der dieser nächstgelegenen Angriffsstelle wird eine mechanische Hebelübersetzung erreicht, welche den Schritthub am Abtriebsteil gegenüber dem Auslenkungshub der Schrittpiezopakete vergrößert. Dadurch können bei entsprechender Arbeitsfrequenz der Piezopakete bei einer Verwendung als Kraftfahrzeugantrieb mit direkter Übertragung auf die Radachse beispielsweise über eine Bremsscheibe Geschwindigkeiten von deutlich über 200 km/h erreicht werden. Außerdem kann durch Phasenverschiebung der Ansteuerung der gegenläufigen Schrittpiezopakete eine Geschwindigkeitssteuerung auf einfach Weise realisiert werden.

Die Erfindung im einzelnen sowie ihre Weiterbildungen und Anwendungsmöglichkeiten werden nachstehend unter Bezugnahme auf die anliegenden Zeichnungen beispielshalber näher beschrieben. In den Zeichnungen zeigt.:
- Fig. 1: eine Seitenansicht eines piezoelektrischen, auf eine Scheibe wirkenden Doppelantriebs in schematisierter Darstellung,
- Fig. 2: eine Frontansicht auf die Antriebsanordnung nach Fig. 1,
- Fig. 3: eine schematische Darstellung einer Hybridantriebsanord- nung unter Verwendung eines piezoelektrischen Antriebs nach den Fig. 1 und 2,
- Fig. 4A und Fig. 4B: eine Seitenansicht und eine Frontansicht eines piezoelektri- schen Antriebs nach der Erfindung, der als Drehantrieb auf eine Abtriebswelle wirkt,
- Fig. 5A und Fig. 5B: eine Seitenansicht und eine Frontansicht eines piezoelektri- schen Antriebs nach der Erfindung, der auf eine Gewinde- spindel wirkt und als Stellantrieb einsetzbar ist,
- Fig. 6A und Fig. 6B: eine Seitenansicht und eine Draufsicht eines piezoelektri- schen Linearantriebs nach der Erfindung,
- Fig. 7: eine Freischalteinrichtung zum Auskuppeln des Klemmpie- zopaketeingriffs,
- Fig. 8: eine schematische Darstellung der elektrischen Anschluß- anordnung der Piezoelemente des Piezoelementenstapels ei- nes Piezopakets für einen piezoelektrischen Antrieb nach der Erfindung, und
- Fig. 9: eine Darstellung ähnlich Fig. 1 mit einer etwas vereinfachten Ausführungsform der Piezomotoranordnung.

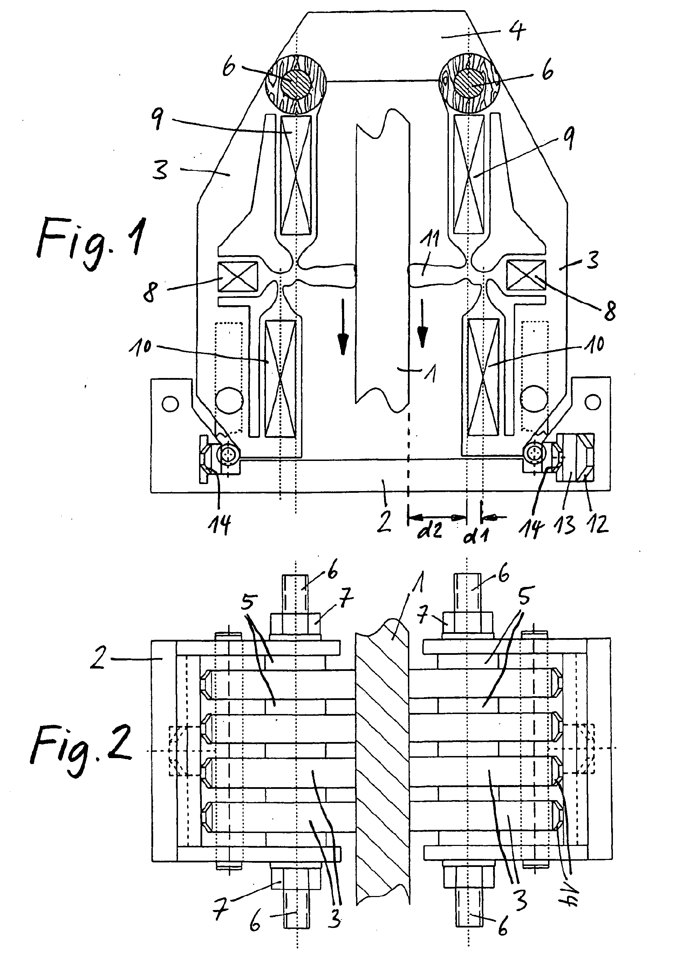

Die Figuren 1 und 2 zeigen in Seitenansicht (Figur 1) und Draufsicht (Figur 2) einen piezoelektrischen Doppelantrieb, der auf beide Seiten einer Bremsscheibe 1 oder sonstigen Antriebsscheibe wirkt. In Figur 1 ist die Bremsscheibe von der Kantenfläche her gesehen, in Figur 2 sieht man sie im Querschnitt. Die Pfeile in Figur 1 geben die Bewegungsrichtung der Bremsscheibe 1 an.

Der in den Figuren 1 und 2 dargestellte piezoelektrische Doppelantrieb besteht aus zwei beiderseits der Bremsscheibe 1 spiegelbildlich angeordneten Einzelantrieben, die über einen gemeinsamen, eine Zange bildenden Rahmen 2 miteinander verbunden sind.

Jeder Einzelantrieb des Doppelantriebs weist eine Reihe von vier Piezostapelanordnungen mit jeweils einem Trägerelement 3 auf. In Figur 1 ist jeweils eine solche Piezopaketanordnung mit dem zugehörigen Trägerelement 3 in der Seitenansicht sichtbar; in Figur 2 ist die Reihe der jeweils vier nebeneinander angeordneten Trägerelemente 3 sichtbar, welche die jeweilige Piezopaketanordnung enthalten. Die Trägerelemente 3 der Einzelantriebe des Doppelantriebs sind, wie Figur 1 zeigt, jeweils über eine Brücke 4 einstückig miteinander verbunden.

Die vier Trägerelemente 3 jeder Reihe sind, wie aus Figur 2 ersichtlich ist, jeweils unter Zwischenlegen einer Distanzscheibe 5 mittels einer Gewindespindel 6 und Spannmuttern 7 reibschlüssig zusammengespannt. Die so zusammengespannten Trägerelemente 3 jedes Einzelantriebs bilden jeweils ein Brückenelement der aus der eingangs erörterten WO 03/005 553 A2 im Prinzip bekannten "halbsteifen" Brücke.

Jedes Trägerelement 3 enthält eine Anordnung von drei Piezopaketen, nämlich einem Klemmpiezopaket 8, einem ersten Schrittpiezopaket 9, und einem zweiten Schrittpiezopaket 10. Die Piezopakete 8, 9 und 10 sind jeweils nur schematisch dargestellt.

Das Klemmpiezopaket 8 ist mit einer senkrecht zur Ebene der Bremsscheibe 1 verlaufenden Piezoelementenstapelrichtung zwischen dem Trägerelement 3 und einem sich auf der Bremsscheibe 1 abstützenden Fuß 11 angeordnet. Die beiden Schrittpiezopakete 9 und 10 haben eine jeweils parallel zueinander und zur Ebene der Bremsscheibe 1 verlaufende Piezoelementenstapelrichtung und sind jeweils zwischen dem Trägerelement 3 und dem Fuß 11 angeordnet, wobei die Verbindungsstellen mit dem Fuß 11 in Längsrichtung des Fußes 11 voneinander versetzt sind.

Die Distanz der Verbindungsstellen oder Angriffsstellen der beiden Schrittpiezostapel 9 und 10 an dem Fuß 11 ist in Figur 1 mit d1 bezeichnet, und die Distanz zwischen der Bremsscheibe 1 und der Verbindungsstelle des der Bremsscheibe am nächsten liegenden Schrittpiezostapels 9 mit dem Fuß 11 ist in Figur 1 mit d2 bezeichnet. Die Anordnung ist damit so getroffen, dass sich bei Aktivierung der beiden Schrittpiezopakete 9 und 10 deren Dehnungshübe addieren und eine entsprechende winkelmäßige Auslenkung des Fußes 11 bewirken, und der aus Figur 1 ersichtliche Umstand, dass die Distanz d2 ein Mehrfaches der Distanz d1 beträgt, erzeugt eine entsprechende Hebelübersetzung, so dass der Auslenkungsweg des an der Bremsscheibe 1 anliegenden Endes des Fußes 11 ein Mehrfaches des Auslenkungswegs der Verbindungsstelle des Fußes 11 mit dem Schrittpiezopaket 9 beträgt.

Die Füße 11 aller Klemmpiezopakete werden im statischen Zustand mittels des Rahmens 2 gegen die Bremsscheibe 1 gespannt. Auch dies ist in Figur 1 relativ gut sichtbar. Im Rahmen 2 befindet sich eine starke gemeinsame Vorspannfeder 12, die auf eine bewegliche Zwischenplatte 13 wirkt, und zwischen der Zwischenplatte 13 auf der einen Seite des Rahmens und dem Rahmen selbst auf dessen anderer Seite und jedem der Tragelemente 3 ist eine Spannfeder 14 angeordnet. Die Anordnung der Trägerelemente 3 verhält sich daher im dynamischen Zustand bei der Betriebsfrequenz wie die eingangs erläuterte "halbsteife" Brücke mit der Folge, dass bei wechselweiser Beaufschlagung jeweils der Klemmpiezopakete einer ersten und einer zweiten Zweiergruppe der insgesamt vier Piezopaketanordnungen jedes Einzelantriebs immer das beaufschlagte Paar von Klemmpiezopaketen 8 Reibschlußkontakt mit der Bremsscheibe 1. hat, während das jeweils andere Klemmpiezopaketpaar momentan von der Bremsscheibe 1 abgehoben ist.

Der Fuß 11 ist, wie die in Figur 1 deutlich sichtbare Querschnittseinführung erkennen lässt, im Bereich der Verbindungsstelle mit dem Schrittpiezopaket 10 über ein durch diese Querschnittseinschnürung gebildetes "Gelenk" mit dem fußseitigen Ende des Klemmpiezostapels 8 verbunden. Dieses Gelenk ermöglicht winkelmäßige Auslenkungen des Fußes 11 relativ zur Stapelachse des Klemmpiezopakets 8.

Die vorstehend mit Bezug auf Figur 1 beschriebene Piezopaketanordnung mit zwei gegensinnig arbeitenden und mit parallel versetzten Wirkungslinien und Angriffsstellen am Fuß 11 angeordneten Schrittpiezopaketen 9 und 10 ermöglicht eine Steuerung von Bewegungsgeschwindigkeit und Bewegungsrichtung des Abtriebsteils, hier der Bremsscheibe 1, bei gleich bleibender Ansteuerfrequenz der Piezopakete durch Steuerung der relativen Phasenlage der Ansteuerung der beiden Schrittpiezopakete 9 und 10. Die Beibehaltung der Ansteuerfrequenz der (sämtlichen) Piezopakete ist notwendig, dass der Wechsel zwischen tragenden und nichttragenden Klemmpiezopaketen auf dem Abtriebsteil, nämlich der Bremsscheibe 1, unabhängig von der Geschwindigkeit des Abtriebsteils kontinuierlich erfolgt.

Werden beide Schrittpiezopakete 9 und 10 phasengleich angesteuert, addieren sich ihre Dehnungsauslenkungen vollständig und man erhält die maximale Schrittgröße des Fußes 11 auf der Scheibe 1. Durch Veränderung der relativen Phasenlage der Ansteuerung der beiden Schrittpiezopakete 9 und 10 unter Berücksichtigung der Hebelübersetzung kann die resultierende Schrittlänge des Fußes 11 auf der Scheibe 1 und damit bei gleich bleibender Schrittfrequenz die erzeugte Geschwindigkeit der Scheibe 10 verändert werden. Durch Veränderung der Phasenlage der Ansteuerung der Schrittpiezopakete zur Ansteuerung der Klemmpiezopakete kann auch die Drehrichtung der Scheibe umgekehrt werden.

Weiter kann der piezoelektrische Motor auch als Generator arbeiten, in dem die Bremsscheibe 1 den Motor "schiebt". Dann erzeugt der als Generator arbeitende piezoelektrische " Motor Energie, die in einer Batterie gespeichert und später wieder als Antriebsenergie für den Motorbetrieb ausgenutzt werden kann. Beim Einsatz eines erfindungsgemäßen piezoelektrischen Motors als Fahrzeugantrieb, inbesondere im Rahmen eines Hybridantriebskonzepts, kann der piezoelektrische Motor also auch zum Bremsen genutzt werden, nämlich im Fahren auf Gefällestrecken und bei normalen Bremsvorgängen, während die hydraulische Bremse dann nur noch bei starken Bremsungen wie beispielsweise Notbremsungen zum Einsatz kommt.

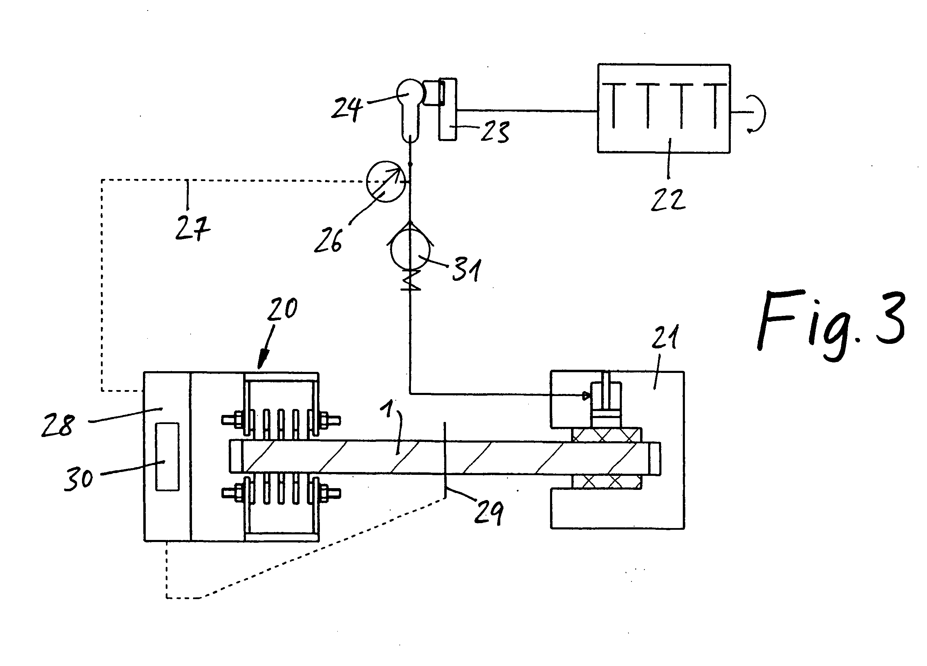

Figur 3 zeigt in Gestalt eines Blockschaltbilds eine Hybridantriebsanordnung bei einem Kraftfahrzeug unter Einbeziehung eines auf eine Bremsscheibe wirkende piezoelektrischen Doppelmotors nach den Figuren 1 und 2.

Die Zeichnung zeigt die Bremsscheibe 1 mit dem hier nur schematisch dargestellten, in seiner Gesamtheit mit 20 bezeichneten piezoelektrischen Doppelmotor, weiter mit einer ebenfalls auf die Bremsscheibe 1 wirkenden hydraulischen Bremse 21, und den schematisch dargestellten Brennkraftmotor 22 des Fahrzeugs. Das Gaspedal oder besser Fahrpedal ist mit 23 und das Bremspedal mit 24 bezeichnet. Die Umschaltung zwischen Brennkraftantrieb und Elektroantrieb über den piezoelektrischen Motor 20 ist hier nicht dargestellt, da solche Umschalteinrichtungen bei Hybridfahrzeugantrieben an sich bekannt sind und nicht zum Gegenstand der Erfindung gehören.

Wird das Fahrzeug mit dem Brennkraftmotor 22 gefahren, ist der piezoelektrische Motor freigeschaltet, d. h. außer Eingriff mit der Bremsscheibe 1. Wie diese Freischaltung realisiert werden kann, wird später noch beschrieben.

Wird das Fahrzeug über den piezoelektrischen Motor 20 angetrieben, arbeitet dieser auch als Betriebsbremse und dann als Generator, der Strom erzeugt anstatt verbraucht. An die Bremsleitung 25 ist ein Bremsdruckaufnehmer 26 angeschlossen, der über eine Signalleitung 27 mit einem Regler 28 verbunden ist. Der Regler 28 spricht auf den Bremsdruck an und erhält außerdem ein Drehzahlsignal von einem die Drehzahl der Bremsscheibe 1 erfassenden Drehzahlmesser 29, und regelt in Abhängigkeit davon den Betrieb des piezoelektrischen Motors 20, nämlich insbesondere die Phasenlage der Ansteuerung der Schrittpiezopakete. Ebenfalls dargestellt, wiederum nur sehr schematisch und als Block innerhalb des Reglers 28 ist eine Batterie 30 oder eine Batterieanordnung, die natürlich körperlich nicht im Regler, sondern an beliebiger Stelle angeordnet sein kann und den piezoelektrischen Motor 20 mit Energie versorgt bzw. bei schiebender Bremsscheibe 1 bei Bremsvorgängen die bei als Generator arbeitendem piezoelektrischem Motor 20 erzeugt elektrische Energie aufnimmt und speichert.

Bei starkem Bremsen, insbesondere bei Notbremsvorgängen, wo der Bremsdruck massiv ansteigt, öffnet ein in der Bremsleitung 25 angeordnetes Überdruckventil 31, so dass dann auch die hydraulische Bremse 21 beaufschlagt wird und in Aktion tritt.

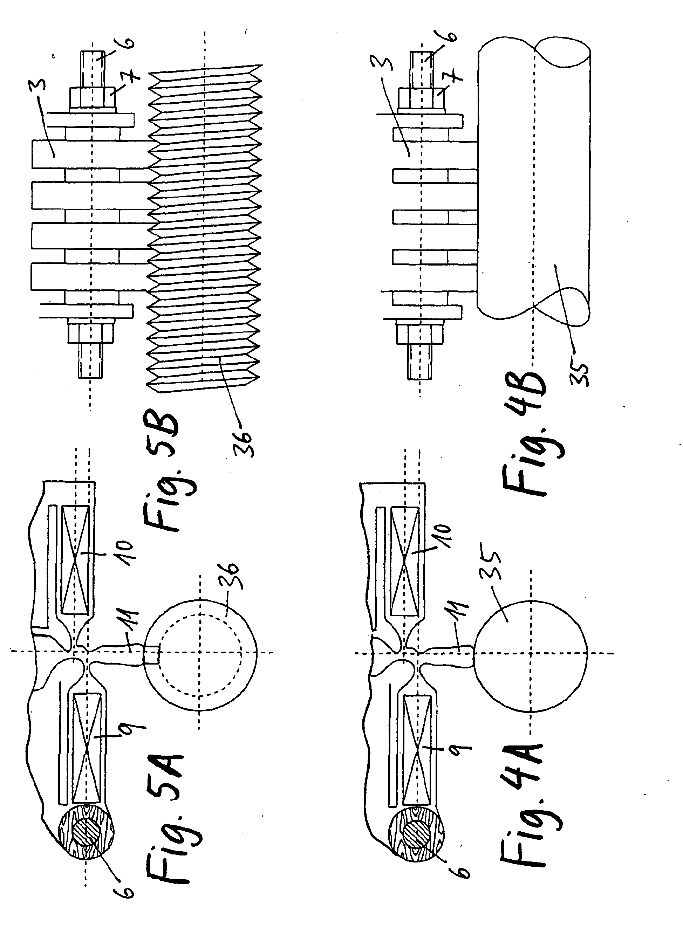

Die Figuren 4A und 4B zeigen in der Seitenansicht (Figur 4A) und in der Frontansicht (Figur 4B) die Anwendung eines piezoelektrischen Antriebs zum Drehen einer Welle 35, wobei der Piezoantrieb nur ausschnittsweise dargestellt ist. Ebenso zeigen die Figuren 5A und 5B in der Seitenansicht (Figur 5A) und in der Frontansicht (Figur 5B) die Anwendung eines solchen piezoelektrischen Antriebs zum Drehen einer Gewindespindel 36 , wobei die Füße 11 der Klemmpiezopakete in die Gewindegänge der Gewindespindel 36 eingreifen. Eine solche Anordnung eignet sich als Stellantrieb für große Stellkräfte.

In den Figuren 4A, 4B, 5A und 5B ist die Piezopaketanordnung jeweils nicht vollständig, sondern abgebrochen dargestellt, da sie in der Anordnung identisch mit der Anordnung jedes Einzelantriebs nach Figur 1 ist. Es versteht sich, dass auch für diese Anwendungen zum Drehen einer Welle oder zum Drehen einer Spindel zweckmäßigerweise ein Doppelantrieb in Gestalt von 2 diametral gegenüberliegenden piezoelektrischen Einzelantrieben Anwendung finden kann, schon um die Druckkräfte der Klemmpiezopakete auf den Wellen- bzw. den Spindelumfang zu kompensieren.

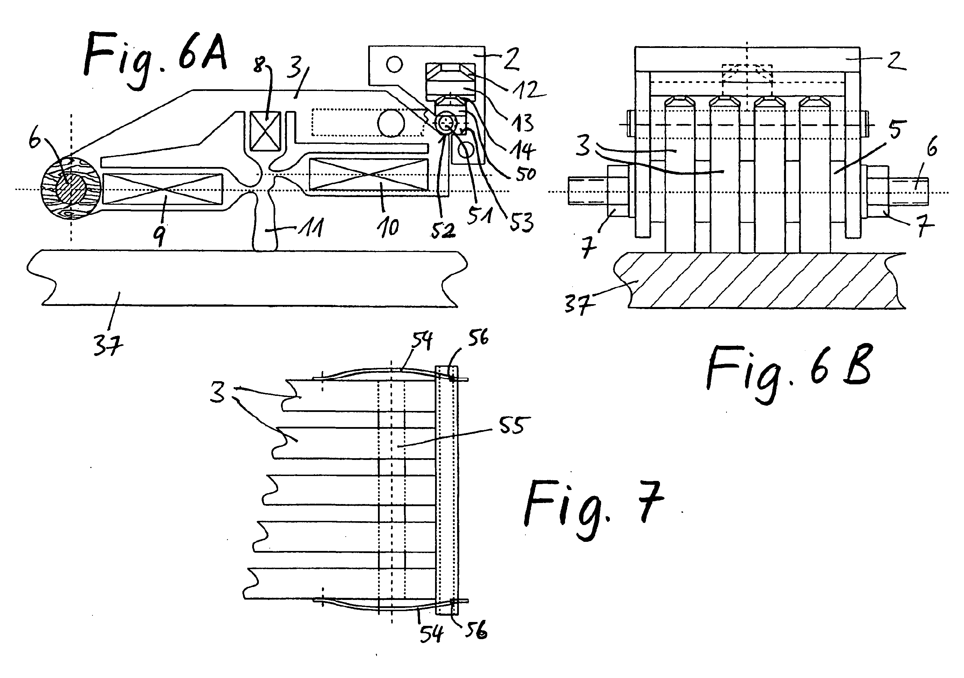

Die Figuren 6A und 6B zeigen in der Seitenansicht (Figur 6A) und in der Frontansicht (Figur 6B) einen als Linearantrieb konzipierten piezoelektrischen Antrieb nach der Erfindung, der als Einzelantrieb dargestellt ist, aber ebenfalls als Doppelantrieb ausgebildet sein kann. Die Anordnung entspricht wiederum der Anordnung jedes Einzelantriebs nach Figur 1, wobei der Rahmen 2 hier als Spannrahmen nur für die Vorspannung der Trägerelemente 3 eines Einzelantriebs konzipiert ist, aber natürlich bei Erweiterung zu einem Doppelantrieb prinzipiell wie in Figur 1 als gemeinsamer Rahmen ausgebildet sein kann. Das Abtriebsteil ist hier als Platte 37 dargestellt, es könnte auch eine Schiene oder Stange sein.

Für alle Anordnungen gilt: Während bei den dargestellten Ausführungsbeispielen der piezoelektrische Antrieb oder, besser gesagt, die Piezopaketanordnungen, am Stator, also am relativ fest stehenden Bezugsteil einer Anordnung angeordnet sind und die Füße 11 der Klemmpiezostapel auf das Abtriebsteil wirken, kann die Anordnung grundsätzlich auch kinematisch umgekehrt sein, nämlich derart, dass die Piezopaketanordnungen an dem Abtriebsteil, also am beweglichen Teil, angeordnet sind und sich die Füße 11 der Klemmpiezopakete am Bezugsteil abstützen und das Abtriebsteil gegenüber dem Bezugsteil bewegen.

Der in allen Zeichnungen dargestellte piezoelektrische Antrieb enthält auch eine Freischalteinrichtung, die das Freischalten des Wirkungseingriffs des piezoelektrischen Motors von der Bremsscheibe 1 oder des sonstigen Abtriebsglieds ermöglichen, beispielsweise, wie schon gesagt, wenn der Antrieb eines Fahrzeugs über den Brennkraftmotor erfolgt. Aufbau und Wirkungsweise der Freischalteinrichtung wird nunmehr anhand der Figuren 6A und 7 beschrieben. In Figur 1 ist die Freischalteinrichtung ebenfalls dargestellt, aber aus Gründen der Klarheit dort nicht mit Bezugszeichen versehen.

Wie aus Figur 6 klar erkennbar ist, wirkt jede Feder 14 nicht unmittelbar auf das jeweilige Trägerelement, sondern über ein Druckstück 50 und eine Rolle 51. Dabei sitzt die Rolle 51 auf einer Schulter 52 des Trägerelements 3 auf.

Wie man weiter aus Figur 6A erkennt, hat der Rahmen 2 auf gleicher Ebene wie die Schulter 52 des Trägerelements 3 eine Schulter 53. Die Rollen 51 aller Trägerelemente 3 sind über eine gemeinsame Betätigungsstange zwischen ihrer auf der Schulter 52 des jeweiligen Trägerlements 3 aufsitzenden Normalposition und einer in der Figur 6A nach rechts verschobenen, auf der Schulter 53 des Rahmens 2 aufsitzenden Position verschiebbar, und zwar mittels zweier Blattfedern 54, die in der eine Draufsicht auf die Tragelemente darstellenden Figur 7 gezeigt sind. Die beiden Blattfedern 54 sind in der in Figur 7 gezeigten, nach außen ausgebauchten Normalposition vorgespannt. Ein wahlweise betätigbarer Elektromagnet 55, der in Figur 7 nur schematisch angedeutet ist, zieht die beiden Blattfedern 54 bei Betätigung an und streckt so die Blattfedern 54. Diese einerseits an den Trägerelementen 3 (oder an einer geeigneten Stelle des Rahmens) festgelegten und andererseits mit jeweils einem axialen Ende der die Rollen 51 betätigenden Stange verbundenen Blattfedern 54 wirken dann wie ein Kniehebel. Beim Strecken der Blattfedern 54 durch die Anziehung durch den Elektromagneten 55 werden die Anlenkstellen 56 mit der Stange wegen der größeren Strecklänge der Blattfedern 54 in Figur 7 nach rechts bewegt, was die Bewegung der in Figur 6A sichtbaren Rollen 51 von der Schulter 52 der Trägerelemente 3 weg auf die Schulter 53 des Rahmens 2 bewirkt. Dann sind aber die Trägerelemente 3 nicht mehr abgestützt und gegen das Abtriebselement, in Figur 6A die Platte 37, vorgespannt, so dass das Abtriebselement frei unter den Füßen 11 der Piezopaketanordnungen bewegbar ist.

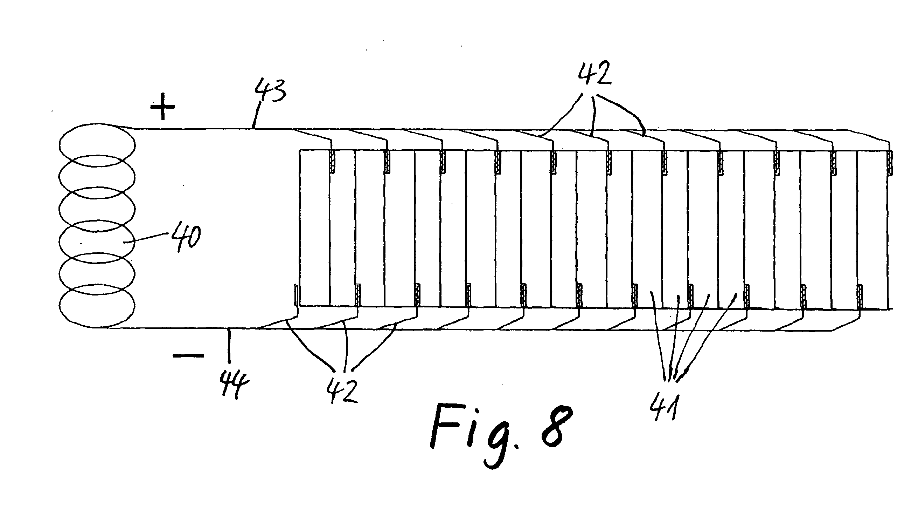

Figur 8 zeigt als Prinzipdarstellung den Aufbau eines Piezopakets in Gestalt eines Piezoelementenstapels mit seinen elektrischen Anschlüssen und seiner elektrischen Ansteuerung.

Die elektrische Ansteuerungsanordnung ist als LC-Schwingkreis gestaltet, nämlich mit einer Schwingspule 40 und den Piezoelementen 41 als Kapazitäten. Durch diese Ansteuerung braucht im Schwingkreis nur jeweils die verbrauchte Energie nachgeliefert zu werden, während der zum Expandieren und Zusammenziehen der Piezopakete notwendige Grundaustausch von Energie innerhalb des Schwingkreises erfolgt.

Wesentlich ist bei der gezeigten Anordnung der Umstand, dass die von den Trennschichten zwischen den Piezoelementen 41 herausgeführten Anschlussfahnen 42 erst mit Abstand vom Piezopaket mit einem gemeinsamen Leiter 43 bzw. 44 verbunden sind, so dass die Anschlussfahnen 42 die Dehnungsschwingungen des Piezopakets aufnehmen und die Verbindungsstellen mit dem gemeinsamen Leiter und die Anschlussstellen der Anschlussbahnen an den Piezoelementen keinen Schwingungsbelastungen unterworfen sind.

Die Anschlussfahnen 42 haben vorzugsweise jeweils die gleiche Breite wie die Piezoelemente, so dass sie großflächig ausgebildet sind. Sie dienen damit auch als Wärmeableiter zur Abführung der in den Piezoelementen erzeugten Wärme. Die Anschlussfahnen 42 sind entgegen bisheriger Praxis nicht nur an den Kanten der Piezoelemente angeschlossen, sondern als Kupferfolien bis in den Piezostapel hineingezogen, wie Figur 8 deutlich erkennen lässt, um die Wärme besser ableiten zu können und außerdem Skineffekte ausnutzen zu können.

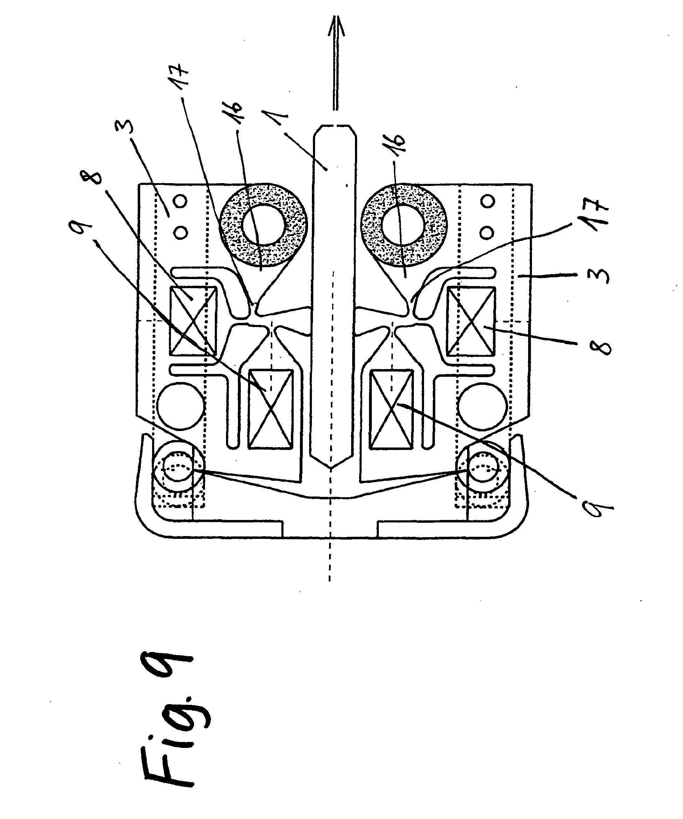

Fig. 9 zeigt in Seitenansicht in ähnlicher Weise wie Fig. 1 einen Doppelantrieb mit piezoelektrischen Motoren, die auf beide Seiten einer Bremsscheibe 1 oder sonstigen Antriebsscheibe wirken, wobei allerdings der Aufbau der Piezomotoren gegenüber der Anordnung nach Fig. 1 etwas vereinfacht ist. Bei dieser Anordnung nach Fig. 9 ist jedem Klemmpiezopaket 8 nur ein Schrittpiezopaket 9 zugeordnet, und das in Fig. 1 vorhandene zweite Schrittpiezopaket 10 ist durch ein festes Widerlager 16 am Bezugsteil 2 ersetzt. Das Widerlager 16 ist über ein Quasi-Gelenk 17 mit dem Fuß verbunden, das etwas beabstandet von der Verbindung des Fußes 11 zum Klemmpiezopaket ist. Die Verbindung zwischen dem Schrittpiezopaket 9 und dem Fuß 11 erfolgt ebenfalls über ein Quasi-Gelenk an einer gewählten Stelle zwischen der Verbindung mit dem Widerlager 16 und dem mit dem Abtriebsteil 1 in Eingriff stehenden Fußende. Durch Wahl der relativen Positionierung der Verbindungsstellen des Fußes 11 mit dem Schrittpiezopaket 9 und mit dem Widerlager 16 kann die Antriebsübersetzung, also das Verhältnis von Ausdehnungsweg des Schrittpiezopakets zu Schrittlänge des am Abtriebsteil angreifenden Fußendes, eingestellt oder gewählt werden.

Bei der Ausführungsform nach Fig. 9 ist zwar gegenüber der Anordnung nach Fig. 1 ein Verlust an maximaler Geschwindigkeit und an Geschwindigkeitsregelungsvermögen durch Phasenverschiebung der Auslenkungen der dortigen beiden Schrittpiezopaketen 9 und 10 gegeben, jedoch ist die vereinfachte Anordnung preiswerter und kleiner und für viele Anwendungen ausreichend.

Bei allen Ausführungsformen kann die Geschwindigkeitsregelung durch Frequenzveränderungen der Ansteuerfrequenz der Klemm- und Schrittpiezopakete erfolgen, natürlich nur innerhalb der Grenzen, die durch die Funktion der "halbsteifen" Brücke gegeben sind, oder auch durch Veränderung des Hubs der Schrittpiezopakete, also von deren Ausdehnung, durch Veränderung der Ansteuerspannung der Schrittpiezopakete.

Erfindungsgemäß ist es auch möglich, die Steifigkeit der halbsteifen Brücke mittels eines in den Zeichnungen nicht dargestellten Verstellmechanismus zu verändern, um diese Steifigkeit beispielsweise der gewählten Ansteuerfrequenz der Piezopakete oder sonstiger Betriebsbedingungen anzupassen. Eine solche Einstellung der Steifigkeit der halbsteifen Brücke kann durch Veränderung der die Brückenelemente bildenden Trägerelemente 3 erreicht werden, indem statt eines festen mechanischen Spannmechanismus (z.B. Spannschraube, Tellerfederpaket oder dergl.) mit fester Spannkraft wiederum ein Piezoaktor Anwendung findet, der durch veränderbare Beaufschlagung mit einer seine Auslenkung bewirkenden elektrischen Spannung mehr oder weniger stark ausgedehnt wird und damit eine mehr oder weniger starke spannende Druckkraft auf die Brückenelemente ausübt. Da für die Spannungsveränderung sehr kleine Wege ausreichen, ist ein Einstellmechanismus mittels eines Piezoaktors dafür exzellent geeignet.

## Patentansprüche

1. Piezoelektrischer Motor zur Erzeugung einer Relativbewegung zwischen einem Bezugsteil (2) und einem Abtriebsteil (1)
mit einer Mehrzahl von zwischen dem Bezugsteil (2) und dem Abtriebsteil (1) angeordneten Klemmpiezopaketen (8), die etwa senkrecht zur Richtung der Relativbewegung zwischen Abtriebsteil und Bezugsteil orientiert sind und jeweils mit ihrem einen Ende am Bezugsteil (2) festgelegt sind und sich mit ihrem anderen Ende über einen Fuß (11) reibschlüssig am Abtriebsteil (1) abstützen,
wobei die Klemmpiezopakete (8) mindestens zwei abwechselnd elektrisch beaufschlagte Gruppen umfassen,
weiter mit einer am Bezugsteil (2) unter Druckvorspannung abgestützten Brücke, an welcher die festgelegten Enden der Klemmpiezopakete (8) abgestützt sind, wobei die Brücke "halbsteif' ausgebildet ist, was bedeutet, dass sie im statischen Zustand ausreichend biegeweich zum Ausgleich von Längentoleranzen der Klemmpiezopakete ist, sich aber im dynamischen Zustand bei der Piezobeaufschlagungsfrequenz starr verhält,
und mit einer Mehrzahl von Schrittpiezopaketen (9, 10), die jeweils einem Klemmpiezopaket (8) zugeordnet und etwa parallel zur Richtung der Relativbewegung zwischen Abtriebsteil und Bezugsteil angeordnet sind sowie jeweils mit ihrem einen Ende am Bezugsteil festgelegt und mit ihrem änderen Ende mit dem Fuß (11) des zugeordneten Klemmpiezopakets verbunden sind,
**dadurch gekennzeichnet,**
**dass** die Klemmpiezopakete (8) mit dem jeweils zugeordneten Fuß (11) über ein Quasi-Gelenk verbunden sind,
**dass** weiter der Fuß (11) an einer von der Verbindungsstelle mit dem zugeordneten Klemmpiezopaket (8) beabstandeten Stelle über ein weiteres Quasi-Gelenk mit einem Gegenlager (16) verbunden ist,
und **dass** das jeweils zugeordnete Schrittpiezopaket (9) an einer zwischen der Verbindungsstelle mit dem Gegenlager (16) und dem abtriebsteilseitigen Ende des Fußes (11) oder der Verbindungsstelle mit dem Klemmpiezopaket gelegenen Stelle mit dem Fuß (11) verbunden ist.

2. Piezoelektrischer Motor nach Anspruch 1, wobei das Gegenlager (16) durch ein zweites Schrittpiezopaket (10) ersetzt ist, derart, dass die beiden Schrittpiezopakete (9, 10) gegensinnig orientiert und mit in Längsrichtung des jeweiligen Klemmpiezopakets (8) versetzten Wirkungslinien angeordnet sind, und dass die Verbindungsstellen der beiden Schrittpiezopakete (9, 10) mit dem Fuß (11) in Längsrichtung des Klemmpiezopakets (8) voneinander und von der Angriffsstelle des Fußes (11) auf dem Abtriebsteil (1) beabstandet sind.

3. Piezoelektrischer Motor nach Anspruch 1 oder 2, wobei die quasi-gelenkige Verbindung des Fußes (11) mit dem Klemmpiezopaket (8) durch eine Querschnittseinschnürung des Fußes gebildet ist.

4. Piezoelektrischer Motor nach Anspruch 2, wobei die Distanz zwischen dem am Abtriebsteil (1) angreifenden Ende des Fußes (11) und der dem Abtriebsteil näher gelegenen Schrittpiezopaket-Verbindungsstelle ein Mehrfaches des gegenseitigen Abstands der Verbindungsstellen der beiden Schrittpiezopakete (9, 10) mit dem Fuß (11) beträgt.

5. Piezoelektrischer Motor nach Anspruch 2, , wobei die beiden Schrittpiezopakete (9, 10) zwar synchron mit dem Klemmpiezopaket (8), aber relativ zueinander und zum Klemmpiezopaket mit veränderlicher Phasenlage elektrisch beaufschlagbar sind.

6. Piezoelektrischer Motor nach einem der Ansprüche 1 bis 5, wobei die halbsteife Brücke in eine Mehrzahl einzelner, jeweils einem Klemmpiezopaket (8) zugeordneter Glieder (3) unterteilt ist, die durch reibschlüssige Verspannung (5, 6, 7) miteinander verbunden sind.

7. Piezoelektrischer Motor nach Anspruch 6, wobei die Glieder (3) der halbsteifen Brücke in Richtung der Relativbewegung zwischen Abtriebsteil und Bezugsteil nach einer Seite versetzt von der Längsachse der Klemmpiezopakete (8) zusammengespannt (5, 6, 7) sind und jeweils an einer nach der anderen Seite von der Längsachse der Klemmpiezopakete (8) in Richtung der Relativbewegung versetzten Stelle einzeln unter Druckvorspannung mit dem Bezugsteil (2) verbunden sind.

8. Piezoelektrischer Motor nach Anspruch 6 oder 7, wobei jedes Glied (3) der Brücke als das jeweilige Klemmpiezopaket (8) und die beiden zugehörigen Schrittpiezopakete (9, 10) aufnehmendes Trägerelement ausgebildet ist.

9. Piezoelektrischer Motor nach einem der Ansprüche 1 bis 8 als Doppelanordnung von zwei spiegelbildlich oder diametral gegenüberliegend angeordneten, auf zwei entgegengesetzt oder diametral gegenüber liegende Seiten des Abtriebsteils (1, 35, 36, 37) wirkenden Einzelmotoranordnungen, die über ein gemeinsames Bezugsteil (2) miteinander verbunden sind.

10. Piezoelektrischer Motor nach Anspruch 9, dessen beide Einzelmotoranordnungen auf die beiden Seiten einer umlaufenden Fahrzeug- oder Radantriebs- oder Bremsscheibe wirken.

11. Piezoelektrischer Motor nach Anspruch 10, der auf eine Radbremsscheibe eines Kraftfahrzeugs wirkt, mit einer elektrischen Regeleinrichtung (28), die über einen Druckfühler (26) den Bremsdruck in der Bremsleitung des Fahrzeugs erfasst und in Abhängigkeit davon den piezoelektrischen Motor auf Generatorbetrieb mit Antrieb durch die schiebende Bremsscheibe unter Abspeicherung der erzeugten elektrischen Energie in einer Batterie (30) umschaltet.

12. Piezoelektrischer Motor nach Anspruch 6 oder 7, wobei die Verspannung der Glieder (3) der halbsteifen Brücke mit Hilfe eines die Spannkraft erzeugenden Piezopakets spannkraftveränderlich erfolgt.

## Claims

1. Piezoelectric motor for generating a relative movement between a reference part (2) and an output part (1)
with a plurality of clamping piezo packets (8) which are arranged between the reference part (2) and the output part (1), are oriented roughly perpendicularly to the direction of relative movement between the output part and reference part and with their one end are each secured to the reference part (2) and with their other end are supported on the output part (1) with frictional engagement via a foot (11),
the clamping piezo packets (8) comprising at least two groups to which electricity is alternately applied,
also with a bridge which is supported on the reference part (2) under compressive prestress and on which the secured ends of the clamping piezo packets (8) are supported, the bridge being embodied in a "semirigid" manner, meaning that it is in the static state sufficiently flexible to compensate for length tolerances of the clamping piezo packets, but behaves rigidly in the dynamic state at the piezo application frequency,
and with a plurality of stepping piezo packets (9, 10) which are each associated with a clamping piezo packet (8), arranged roughly parallel to the direction of relative movement between the output part and the reference part and also with their one end are each secured to the reference part and with their other end are connected to the foot (11) of the associated clamping piezo packet,
**characterized in that**
the clamping piezo packets (8) are connected to the respectively associated foot (11) via a quasi-joint,
**in that** furthermore the foot (11) is connected to a counter bearing (16) via a further quasi-joint at a point set apart from the point of connection to the associated clamping piezo packet (8),
and **in that** the respectively associated stepping piezo packet (9) is connected to the foot (11) at a point positioned between the point of connection to the counter bearing (16) and the output part-side end of the foot (11) or the point of connection to the clamping piezo packet.

2. Piezoelectric motor according to claim 1, wherein the counter bearing (16) is replaced by a second stepping piezo packet (10) in such a way that the two stepping piezo packets (9, 10) are oriented in opposite directions and arranged with lines of action which are offset in the longitudinal direction of the respective clamping piezo packet (8), and in that the points of connection of the two stepping piezo packets (9, 10) to the foot (11) are set apart from each other in the longitudinal direction of the clamping piezo packet (8) and from the point of engagement of the foot (11) on the output part (1).

3. Piezoelectric motor according to claim 1 or 2, wherein the quasi-articulated connection of the foot (11) to the clamping piezo packet (8) is formed by a cross-sectional constriction of the foot.

4. Piezoelectric motor according to claim 2, wherein the distance between the end of the foot (11) that engages on the output part (1) and the stepping piezo packet connection point which is positioned closer to the output part is a multiple of the mutual distance of the points of connection of the two stepping piezo packets (9, 10) to the foot (11).

5. Piezoelectric motor according to claim 2, wherein electricity can be applied to the two stepping piezo packets (9, 10) in synchronisation with the clamping piezo packet (8), but with a variable phase position relative to each other and to the clamping piezo packet.

6. Piezoelectric motor according to one of claims 1 to 5, wherein the semirigid bridge is divided into a plurality of individual members (3) which are each associated with a clamping piezo packet (8) and joined together by frictionally engaged bracing (5, 6, 7).

7. Piezoelectric motor according to claim 6, wherein the members (3) of the semirigid bridge are braced together (5, 6, 7) in the direction of relative movement between the output part and the reference part so as to be offset toward one side from the longitudinal axis of the clamping piezo packets (8) and are each individually connected to the reference part (2) under compressive prestress at a point which is offset toward the other side from the longitudinal axis of the clamping piezo packets (8) in the direction of relative movement.

8. Piezoelectric motor according to claim 6 or 7, wherein each member (3) of the bridge is embodied as a carrier element receiving the respective clamping piezo packet (8) and the two associated stepping piezo packets (9, 10).

9. Piezoelectric motor according to one of claims 1 to 8, as a double arrangement of two individual motor arrangements which are arranged in a mirror-inverted manner or diametrically opposing each other, act on two sides of the output part (1, 35, 36, 37) that are positioned opposite or diametrically opposing each other, and are joined together via a common reference part (2).

10. Piezoelectric motor according to claim 9, the two individual motor arrangements of which act on the two sides of a revolving vehicle or wheel drive or brake disc.

11. Piezoelectric motor according to claim 10, which acts on a wheel brake disc of a motor vehicle, with an electric regulating means (28) which detects the brake pressure in the brake line of the vehicle via a pressure transducer (26) and, as a function thereof, switches the piezoelectric motor over to generator mode with driving by the pushing brake disc, the electrical energy generated being stored in a battery (30).

12. Piezoelectric motor according to claim 6 or 7, wherein the members (3) of the semirigid bridge are braced with variable tensioning force with the aid of a piezo packet generating the tensioning force.

## Revendications

1. Moteur piézoélectrique destiné à générer un mouvement relatif entre un élément de référence (2) et un élément mené (1),
comportant une pluralité de paquets piézo de serrage (8) disposés entre l'élément de référence (2) et l'élément mené (1) qui sont orientés approximativement perpendiculairement à la direction du mouvement relatif entre l'élément mené et l'élément de référence et immobilisés, par l'une de leurs extrémités, sur l'élément de référence (2) et qui prennent appui par friction, par l'autre de leurs extrémités, sur l'élément mené (1) par l'intermédiaire d'un pied (11),
les paquets piézo de serrage (8) comprenant au moins deux groupes alimentés alternativement en électricité,
et une plaque de pontage qui prend appui sur l'élément de référence (2) sous précontrainte de pression et sur laquelle prennent appui les extrémités immobilisés des paquets piézo de serrage (8), la plaque de pontage étant réalisée de manière "semi-rigide" ce qui signifie qu'à l'état statique, elle est suffisamment élastique en flexion pour compenser les tolérances de longueur des paquets piézo de serrage mais qu'à l'état dynamique, elle reste rigide à la fréquence de fonctionnement piézo,
et une pluralité de paquets piézo de déplacement (9, 10) respectivement associés à un paquet piézo de serrage (8) qui sont orientés approximativement parallèlement à la direction du mouvement relatif entre l'élément mené et l'élément de référence et immobilisés, respectivement par l'une de leurs extrémités, sur l'élément de référence et reliés, par l'autre de leurs extrémités, avec le pied (11) du paquet piézo de serrage associé,
**caractérisé en ce que**
les paquets piézo de serrage (8) sont reliés au pied (11) respectivement associé par l'intermédiaire d'une quasi-articulation,
**en ce que** le pied (11) est relié, au niveau d'un point éloigné du point de liaison avec le paquet piézo de serrage (8) associé, à une butée (16) par l'intermédiaire d'une autre quasi-articulation,
et **en ce que** le paquet piézo de déplacement (9) respectivement associé est relié au pied (11) au niveau d'un point situé entre le point de liaison avec la butée (16) et l'extrémité côté élément mené du pied (11) ou le point de liaison avec le paquet piézo de serrage.

2. Moteur piézoélectrique selon la revendication 1, la butée (16) étant remplacée par un deuxième paquet piézo de déplacement (10) de manière que les deux paquets piézo de déplacement (9, 10) soient orientés dans la direction opposée l'une par rapport à l'autre et que leurs lignes de traction soient décalées dans le sens longitudinal du paquet piézo de serrage (8) respectif, et que les points de liaison des deux paquets piézo de déplacement (9, 10) soient éloignés l'un de l'autre et du point de prise du pied (11) sur l'élément mené (1), par le pied (11) dans le sens longitudinal du paquet piézo de serrage (8).

3. Moteur piézoélectrique selon l'une des revendications 1 ou 2, la liaison quasi-articulée du pied (11) avec le paquet piézo de serrage (8) étant formée par un rétrécissement de la section du pied.

4. Moteur piézoélectrique selon la revendication 2, la distance entre l'extrémité du pied (11) prenant appui sur l'élément mené (1) et le point de liaison du paquet piézo de déplacement plus proche de l'élément mené est un multiple de la distance réciproque entre les points de liaison des deux paquets piézo de déplacement (9, 10) et le pied (11).

5. Moteur piézoélectrique selon la revendication 2, les deux paquets piézo de déplacement (9, 10) étant aptes à être alimentés en électricité de manière synchrone avec le paquet piézo de serrage (8) mais avec une relation de phase variable de manière relative l'un par rapport à l'autre et par rapport au paquet piézo de serrage.

6. Moteur piézoélectrique selon l'une des revendications 1 à 5, la plaque de pontage semi-rigide étant subdivisée en une pluralité d'organes (3) individuels respectivement associés à un paquet piézo de serrage (8) et reliés entre eux moyennant un serrage par friction (5, 6, 7).

7. Moteur piézoélectrique selon la revendication 6, les organes (3) de la plaque de pontage étant serrés ensemble (5, 6, 7) dans la direction du mouvement relatif entre l'élément mené et l'élément de référence de manière décalée d'un côté de l'axe longitudinal des paquets piézo de serrage (8) et reliés individuellement à l'élément de référence (2) au niveau d'un point décalé de l'autre côté de l'axe longitudinal des paquets piézo de serrage (8) dans la direction du mouvement relatif sous précontrainte de pression.

8. Moteur piézoélectrique selon l'une des revendications 6 ou 7, chaque organe (3) de la plaque de pontage étant réalisé comme un élément porteur destiné à recevoir le paquet piézo de serrage (8) respectif et les deux paquets piézo de déplacement (9, 10) associés.

9. Moteur piézoélectrique selon l'une des revendications 1 à 8 sous la forme d'un agencement double de deux agencements individuels de moteurs disposés de manière symétrique ou diamétralement opposé qui agissent sur deux côtés opposés ou diamétralement opposés de l'élément mené (1, 35, 36, 37) et qui sont reliés ensemble par l'intermédiaire d'un élément de référence (2) commun.

10. Moteur piézoélectrique selon la revendication 9, dont les deux agencements de moteurs individuels agissent sur les deux faces d'un disque tournant de véhicule, de roue motrice ou de frein.

11. Moteur piézoélectrique selon la revendication 10 agissant sur un disque de frein de roue d'un véhicule automobile comportant un dispositif de régulation électrique (28) qui, par l'intermédiaire d'un capteur de pression (26), détecte la pression de freinage dans la canalisation de frein du véhicule et commute, en fonction de la pression relevée, le moteur piézoélectrique en mode génératrice, avec entraînement par le disque de frein propulseur, en emmagasinant l'énergie électrique généré dans une batterie (30).

12. Moteur piézoélectrique selon l'une des revendications 6 ou 7, le serrage des organes (3) de la plaque de pontage semi-rigide s'effectuant à l'aide d'un paquet piézo générant la force de serrage, celle-ci étant variable.
